# EUROPÄISCHE PATENTSCHRIFT

(11) **EP 2 133 996 B1**
(45) Veröffentlichungstag und Bekanntmachung des Hinweises auf die Patenterteilung: **01.12.2010**
(21) Anmeldenummer: 09004836.4
(22) Anmeldetag: 01.04.2009
(51) Int. Cl.: H03K 17/16, H03K 17/082, H01H 47/00

(54) **Schaltung zur Ansteuerung eines elektrischen Verbrauchers**
Switch for controlling an electrical load
Commutateur destiné à la commande d'un récepteur électrique

(30) Priorität: 09.06.2008 DE 102008028202
(43) Veröffentlichungstag der Anmeldung: 16.12.2009
(73) Patentinhaber: E.G.O. Elektro-Gerätebau GmbH, 75038 Oberderdingen (DE)
(72) Erfinder: Kraus, Randolf, 75015 Bretten (DE)
(74) Vertreter: Patentanwälte Ruff, Wilhelm, Beier, Dauster & Partner

(56) Entgegenhaltungen:
- EP-A- 1 239 573
- DE-A1- 3 434 343

## Beschreibung

Die Erfindung betrifft eine Schaltung zur Ansteuerung eines elektrischen Verbrauchers.

Bei Schaltungen zur Ansteuerung von elektrischen Verbrauchern wird üblicherweise ein elektrisch ansteuerbares Schaltmittel, beispielsweise ein Transistor, dazu verwendet, den elektrischen Verbraucher mit einer Spannung bzw. einem Strom zu beaufschlagen oder diesen von der Spannung bzw. vom Strom zu trennen. Hierzu wird das Schaltmittel geschlossen bzw. geöffnet. Bei dem elektrischen Verbraucher kann es sich beispielsweise um eine Erregerspule eines Relais handeln, wobei das Relais anzieht, wenn die Erregerspule bei geschlossenem Schaltmittel ausreichend bestromt ist, und das Relais andernfalls abfällt.

Wenn der als elektrisch ansteuerbares Schaltmittel wirkende Transistor beispielsweise aufgrund von Überspannungen, elektrostatischen Entladungen etc. beschädigt wird, kann dies zur Folge haben, dass der Transistor unabhängig von einem an seinem Steuereingang anstehenden Steuersignal dauerhaft durchgeschaltet ist, wodurch die Erregerspule dauerhaft bestromt wird, d.h., das Relais ist dauerhaft angezogen. Dies kann zu sicherheitskritischen Zuständen führen, wenn beispielsweise eine elektrische Heizung durch das Relais dauerhaft aktiviert wird, wodurch eine Überhitzung verursacht werden kann.

Die EP 1 239 573 A1 zeigt einen Gleichrichter, dessen Ausgangsspannungscharakteristik in einem Überspannungsfall verändert wird.

### Aufgabe und Lösung

Der Erfindung liegt die Aufgabe zugrunde, eine Schaltung zur Ansteuerung eines elektrischen Verbrauchers zur Verfügung zu stellen, die eine sichere Ansteuerung des elektrischen Verbrauchers ermöglicht, insbesondere dann, wenn das elektrisch ansteuerbare Schaltmittel aufgrund einer Fehlfunktion bzw. eines Defekts einen unerwünschten Schaltzustand aufweist, d.h. einen Schaltzustand, der sich aufgrund einer Ansteuerung des Schaltmittels an diesem nicht einstellen dürfte.

Die Erfindung löst diese Aufgabe durch Schaltung nach Anspruch 1. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Die erfindungsgemäße Schaltung zur Ansteuerung eines elektrischen Verbrauchers umfasst ein Netzteil, beispielsweise ein Schaltnetzteil, das aus einer Eingangsspannung, beispielsweise einer Netzwechselspannung, eine Ausgangsspannung, beispielsweise eine geregelte Ausgangsgleichspannung, erzeugt, wobei die Ausgangsspannung durch geeignete Ansteuerung des Netzteils, beispielsweise mittels eines Ansteuersignals, einstellbar ist, beispielsweise auf zwei unterschiedliche Ausgangsspannungsniveaus. Die Schaltung umfasst ferner ein elektrisch ansteuerbares Schaltmittel, beispielsweise einen Transistor oder ein Relais, das in Abhängigkeit von seinem Schaltzustand den elektrischen Verbraucher mit der Ausgangsspannung beaufschlagt oder nicht mit der Ausgangsspannung beaufschlagt. Eine Schaltzustandsüberwachungseinheit ist dazu ausgebildet, den Schaltzustand des Schaltmittels zu überwachen und das Netzteil derart anzusteuern, dass die Ausgangsspannung des Netzteils verändert wird, insbesondere reduziert wird, wenn der Schaltzustand des Schaltmittels nicht mit einem gewünschten Schaltzustand des Schaltmittels übereinstimmt, d.h., wenn das Schaltmittel keinen Schaltzustand aufweist bzw. einnimmt, der einem Zustand eines Ansteuersignals des Schaltmittels entspricht. Aufgrund der Veränderung der Ausgangsspannung bei einem unerwünschten Schaltzustand, d.h. im Fehlerfall, wird der elektrische Verbraucher im Fehlerfall mit einer geänderten Ausgangsspannung, beispielsweise mit einer deutlich reduzierten Ausgangsspannung, beaufschlagt, wodurch eine Gefährdung durch den elektrischen Verbraucher ausgeschlossen wird.

Der elektrische Verbraucher ist eine Erregerspule eines Relais. Bevorzugt wird die Ausgangsspannung des Netzteils bis auf einen Spannungspegel reduziert, der ein Anziehen oder Durchschalten des Relais verhindert bzw. ein Abfallen oder Sperren des Relais bewirkt, wenn der Schaltzustand des Schaltmittels im Fehlerfall nicht mit einem gewünschten Schaltzustand des Schaltmittels übereinstimmt. Auf diese Weise kann im Fehlerfall bewirkt werden, dass ein durch das Relais angesteuerter Verbraucher von einer Spannungsversorgung, beispielsweise von der Netzspannung, getrennt wird.

In einer Weiterbildung ist das elektrisch ansteuerbare Schaltmittel ein Transistor in bipolarer Technologie oder vom MOS-Typ. In einer Weiterbildung umfasst die Schaltung den elektrischen Verbraucher, wobei das elektrisch ansteuerbare Schaltmittel und der elektrische Verbraucher seriell zwischen Ausgänge des Netzteils eingeschleift sind, an denen die Ausgangsspannung ansteht.

In einer Weiterbildung erzeugt die Schaltzustandsüberwachungseinheit ein Steuersignal in Abhängigkeit von einem Ergebnis der Überwachung, beaufschlagt das Netzteil mit dem Steuersignal und das Netzteil erzeugt die Ausgangsspannung mit einem Pegel, der von dem Steuersignal abhängt.

In einer Weiterbildung umfasst die Schaltzustandsüberwachungseinheit eine Ansteuerlogikeinheit, die in Abhängigkeit von einem Ansteuersignal für das elektrisch ansteuerbare Schaltmittel an einem Ausgang ein Rechteckspannungssignal oder ein Gleichspannungssignal erzeugt, einen Transistor, einen ersten Widerstand, eine erste Diode und eine zweite Diode, einen ersten Kondensator und einen zweiten Kondensator, wobei der erste Widerstand und der erste Kondensator seriell zwischen einen Verbindungsknoten des elektrisch ansteuerbaren Schaltmittels und des elektrischen Verbrauchers und ein Bezugspotential eingeschleift sind, wobei ein Verbindungsknoten des ersten Widerstands und des ersten Kondensators mit einem Steueranschluss des Transistors verbunden ist, der zweite Kondensator und die erste Diode seriell zwischen den Ausgang der Ansteuerlogikeinheit und den Steueranschluss des Transistors eingeschleift sind, die Kathode der ersten Diode mit der Anode der zweiten Diode und dem zweiten Kondensator verbunden ist, die Kathode der zweiten Diode mit dem Bezugspotential verbunden ist und das Steuersignal durch den Transistor erzeugt wird. Bevorzugt umfasst die Schaltzustandsüberwachungseinheit weiter eine Zenerdiode, einen Optokoppler und einen zweiten Widerstand, wobei die Zenerdiode einer Kollektor-Emitter-Strecke bzw. einer Drain-Source-Strecke des Transistors parallel geschaltet ist, der zweite Widerstand, eine Leuchtdiode des Optokopplers und die Zenerdiode seriell zwischen die Ausgänge des Netzteils eingeschleift sind und an einem Ausgang des Optokopplers das Steuersignal ansteht.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### Kurzbeschreibung der Zeichnungen

Vorteilhafte Ausführungsformen der Erfindung sind in der Zeichnung schematisch dargestellt und werden nachfolgend beschrieben. Hierbei zeigt:

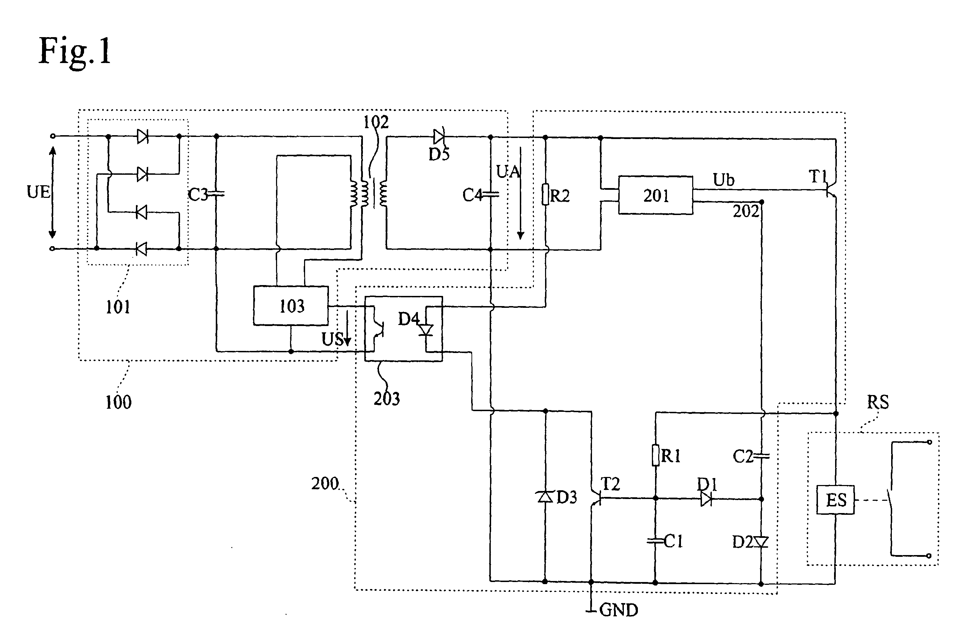

- Fig.1: eine Schaltung zur Ansteuerung eines elektrischen Verbrau- chers gemäß einer ersten Ausführungsform.

Fig.1 zeigt eine Schaltung zur Ansteuerung eines elektrischen Verbrauchers in Form einer Erregerspule ES eines Relais RS gemäß einer ersten Ausführungsform.

Die Schaltung umfasst ein Netzteil 100, das aus einer Eingangsspannung in Form einer Netzwechselspannung UE eine geregelte Ausgangsgleichspannung UA erzeugt. Das Netzteil 100 umfasst in der dargestellten Verschaltung einen Brückengleichrichter 101, einen galvanisch trennenden Übertrager 102, Glättungskondensatoren C3 und C4, eine Gleichrichterdiode D5 und einen Schaltregler 103, der von einer Hilfswicklung des Übertragers 102 gespeist wird. Der Schaltregler 103 steuert in herkömmlicher Weise den Betrieb des Netzteils 100, wobei die Ausgangsgleichspannung UA des Netzteils 100 mittels eines Steuersignals US einstellbar ist, welches von einer Schaltzustandsüberwachungseinheit 200 an den Schaltregler 103 angelegt wird. Der Schaltregler regelt die Ausgangsgleichspannung UA in Abhängigkeit von dem Steuersignal US entweder auf einen Normalbetriebswert, beispielsweise 12V, oder einen Stand-by-Wert, beispielsweise 1V oder weniger.

Die Schaltung umfasst ferner ein elektrisch ansteuerbares Schaltmittel in Form eines Transistors T1, der in Abhängigkeit von seinem Schaltzustand die Erregerspule ES mit der Ausgangsgleichspannung UA beaufschlagt oder nicht. Der Transistor T1 und die Erregerspule ES sind seriell zwischen Ausgänge des Netzteils 100 eingeschleift, an denen die Ausgangsgleichspannung UA ansteht.

Die Schaltzustandsüberwachungseinheit 200 ist dazu ausgebildet, den Schaltzustand des Transistors T1 zu überwachen und das Netzteil 100 bzw. den Schaltregler 103 derart anzusteuern, dass die Ausgangsgleichspannung UA auf den Stand-by-Wert reduziert wird, wenn der Schaltzustand des Transistors T1 nicht mit einem gewünschten bzw. erwarteten Schaltzustand des Transistors T1 übereinstimmt. Der Schaltzustand des Transistors T1 stimmt beispielsweise dann nicht mit dem gewünschten Schaltzustand überein, wenn ein Pegel eines Transistorsteuersignals UB, das durch eine Ansteuerlogikeinheit 201 der Schaltzustandsüberwachungseinheit 200 an die Basis des Transistors T1 angelegt wird, ein Abschalten bzw. Sperren des Transistors T1 bewirken müsste, der Transistor T1 jedoch weiterhin leitend bleibt, beispielsweise aufgrund einer Beschädigung des Transistors T1 durch eine Überspannung. Da die Erregerspule ES in diesen Fehlerfall unerwünscht weiter durch den Transistor T1 bestromt wird, bleibt das Relais RS angezogen bzw. zieht an, wodurch ein durch das Relais RS gespeister, nicht gezeigter Verbraucher weiter mit Energie versorgt wird. Dies kann zu kritischen Betriebszuständen führen.

Um derartige kritische Betriebszustände zu vermeiden, wird in dem oben genannten Fehlerfall die Ausgangsgleichspannung UA des Netzteils 100 auf den Stand-by-Wert reduziert, der ein Anziehen des Relais RS sicher verhindert bzw. ein Abfallen des Relais RS bewirkt.

Zum Bestimmen, ob der Schaltzustand des Transistors T1 nicht mit einem gewünschten Schaltzustand übereinstimmt, d.h., ob ein Fehlerzustand vorliegt, umfasst die Schaltzustandsüberwachungseinheit 200 die Ansteuerlogikeinheit 201, die in Abhängigkeit von dem Ansteuersignal UB für den Transistor T1 an einem Ausgang 202 ein Rechteckspannungssignal oder ein Gleichspannungssignal erzeugt, einen Transistor T2, einen ersten Widerstand R1, einen zweiten Widerstand R2, eine erste Diode D1 und eine zweite Diode D2, einen ersten Kondensator C1, einen zweiten Kondensator C2, eine Zenerdiode D3 und einen Optokoppler 203.

Eine galvanische Trennung mit Hilfe des galvanisch trennenden Übertragers 102 ist für die Funktion der Schaltung nicht zwingend notwendig. Wenn beispielsweise ein nicht galvanisch trennender Übertrager verwendet wird, kann der Optokoppler 203 durch einen einfachen Transistor ersetzt werden.

Der erste Widerstand R1 und der erste Kondensator C1 sind seriell zwischen einen Verbindungsknoten des Transistors T1 und der Erregerspule ES und ein Bezugspotential GND eingeschleift, wobei ein Verbindungsknoten des ersten Widerstands R1 und des ersten Kondensators C1 mit der Basis des Transistors T2 verbunden ist, der zweite Kondensator C2 und die erste Diode D1 seriell zwischen den Ausgang 202 der Ansteuerlogikeinheit 201 und die Basis des Transistors T2 eingeschleift sind, die Kathode der ersten Diode D1 mit der Anode der zweiten Diode D2 und dem zweiten Kondensator C2 verbunden ist und die Kathode der zweiten Diode D2 mit dem Bezugspotential GND verbunden ist.

Die Zenerdiode D3 ist der Kollektor-Emitter-Strecke des Transistors T2 parallel geschaltet, der zweite Widerstand R2, eine Leuchtdiode D4 des Optokopplers 203 und die Zenerdiode D3 sind seriell zwischen die Ausgänge des Netzteils 100 eingeschleift. An einem Ausgang des Optokopplers 203 steht das Steuersignal US an.

Nachfolgend wird der Betrieb der in Fig. 1 gezeigten Schaltung beschrieben.

Wenn die Ausgangsgleichspannung UA mit ihrem Normalbetriebswert erzeugt wird und die Erregerspule ES nicht bestromt werden soll, erzeugt die Ansteuerlogikeinheit 201 das Ansteuersignal UB an der Basis des Transistors T1 mit einem niedrigen Pegel und am Ausgang 202 der Ansteuerlogikeinheit 201 wird eine Gleichspannung ausgegeben. Bei ordnungsgemäßer Funktion des Transistors T1 sperrt dieser, d.h. ist nicht leitend. Die Basis des Transistors T2 wird über den Widerstand R1 und die Erregerspule nach Masse gezogen, wodurch der Transistor T2 sperrt.

Die Ausgangsgleichspannung UA wird für diesen Betriebsfall auf den Normalbetriebswert geregelt, wobei die Zenerdiode D3, der Widerstand R2, der Optokoppler 203 und der Schaltregler 103 eine Regelschleife bilden. Wenn die Ausgangsspanung UA über den Normalbetriebswert ansteigt, wird die Durchbruchspannung der Zenerdiode D3 überschritten, wodurch ein Stromfluss durch den Widerstand R2, die Leuchtdiode D4 und die Zenerdiode D3 bewirkt wird. Der Stromfluss durch die Leuchtdiode D4 bewirkt eine Veränderung des Steuersignals US am Schaltregler 103, wodurch der Schaltregler 103 die durch den Übertrager 102 übertragene Leistung reduziert, wodurch wiederum die Ausgangsgleichspannung UA abnimmt.

Wenn das Relais RS anziehen soll, wird am Ausgang 202 der Ansteuerlogikeinheit 201 zunächst eine Rechteckspannung ausgegeben, die aufgrund der Dioden D1 und D2 und der Kondensatoren C1 und C2 bewirkt, dass sich an der Basis des Transistors T2 eine negative Spannung einstellt. Zeitverzögert oder gleichzeitig erzeugt die Ansteuerlogikeinheit 201 das Ansteuersignal UB an der Basis des Transistors T1 mit einem hohen Pegel, wodurch der Transistor T1 durchschaltet. Dies bewirkt einen Stromfluss durch den Widerstand R1 in Richtung des Kontenpunkts T2, R1, C1 und D1, wobei aufgrund des Rechtecksignals am Ausgang 202 der Ansteuerlogikeinheit 201 die Spannung an der Basis des Transistors T2 nicht auf Werte ansteigt, die ein Durchschalten des Transistors T2 ermöglichen. Das Signal US ändert folglich seinen Zustand nicht.

Wenn das Relais RS abfallen soll, erzeugt die Ansteuerlogikeinheit 201 das Ansteuersignal UB an der Basis des Transistors T1 wieder mit einem niedrigen Pegel und am Ausgang 202 der Ansteuerlogikeinheit 201 wird wieder die Gleichspannung ausgegeben. Wenn der Transistor T1 trotz des niedrigen Pegels an seiner Basis aufgrund eines Defekts weiter durchsteuert, nimmt die Spannung an der Basis des Transistors T2 auf Werte zu, die ein Durchsteuern des Transistors T2 bewirken, da eine Entladung des Kondensators C1 aufgrund des Gleichspannungssignals am Ausgang 202 Ansteuerlogikeinheit 201 nicht mehr stattfindet.

Der durchgesteuerte Transistor T2 schließt in Folge die Zenerdiode D3 kurz, wodurch sich aufgrund der Regelschleife die Ausgangsgleichspannung UA um diejenige Spannung verringert, die bei gesperrtem Transistor T2 an der Zenerdiode D3 abgefallen ist. Aufgrund der nun stark reduzierten Ausgangsgleichspannung UA fließt lediglich ein minimaler Strom durch die Erregerspule ES, wodurch das Relais RS abfällt und nicht mehr anziehen kann. Die Schaltung befindet sich folglich in einem unkritischen Zustand.

Selbst wenn aufgrund einer Überspannung beide Transistoren T1 und T2 dauernd leitend sind, wird das Signal US mit einem Pegel erzeugt, der zur Erzeugung der Ausgangsgleichspannung mit dem Stand-by-Wert führt, wodurch sich ein unkritischer Zustand mit abgefallenem Relais RS einstellt.

Ein Ausfall der Schaltzustandsüberwachungseinheit 200 bzw. der Ansteuerlogikeinheit 201 kann ebenfalls abgefangen werden, da für diesen Fall die Ansteuerlogikeinheit 201 kein Wechselsignal mehr ausgibt, wodurch sich ebenfalls der unkritische Zustand mit abgefallenem Relais RS einstellt.

Die gezeigten Ausführungsformen ermöglichen eine sichere Ansteuerung des elektrischen Verbrauchers, insbesondere dann, wenn das elektrisch ansteuerbare Schaltmittel aufgrund einer Fehlfunktion nicht mehr geöffnet werden kann.

## Patentansprüche

1. Schaltung zur Ansteuerung eines elektrischen Verbrauchers (ES), umfassend:
- ein Netzteil (100), das aus einer Eingangsspannung (UE) eine Ausgangsspannung (UA) erzeugt, wobei die Ausgangsspannung (UA) einstellbar ist,
- ein elektrisch ansteuerbares Schaltmittel (T1), das in Abhängigkeit von seinem Schaltzustand den elektrischen Verbraucher (ES) mit der Ausgangsspannung (UA) beaufschlagt oder nicht mit der Ausgangsspannung (UA) beaufschlagt, und
- eine Schaltzustandsüberwachungseinheit (200), die dazu ausgebildet ist,
- den Schaltzustand des Schaltmittels (T1) zu überwachen und
- das Netzteil (100) derart anzusteuern, dass die Ausgangsspannung (UA) des Netzteils (100) verändert wird, insbesondere reduziert wird, wenn der Schaltzustand des Schaltmittels (T1) nicht mit einem gewünschten Schaltzustand des Schaltmittels (T1) übereinstimmt,
**dadurch gekennzeichnet, dass**
- der elektrische Verbraucher eine Erregerspule (ES) eines Relais (RS) ist.

2. Schaltung nach Anspruch 1, **dadurch gekennzeichnet, dass** die Ausgangsspannung (UA) des Netzteils (100) bis auf einen Spannungspegel reduziert wird, der ein Anziehen des Relais (RS) verhindert bzw. ein Abfallen des Relais (RS) bewirkt, wenn der Schaltzustand des Schaltmittels (T1) nicht mit einem gewünschten Schaltzustand des Schaltmittels (T1) übereinstimmt.

3. Schaltung nach Anspruch 1 oder 2, **dadurch gekennzeichnet, dass** das elektrisch ansteuerbare Schaltmittel ein Transistor (T1) ist.

4. Schaltung nach einem der vorhergehenden Ansprüche, **dadurch gekennzeichnet, dass** die Schaltung den elektrischen Verbraucher (ES) umfasst, wobei das elektrisch ansteuerbare Schaltmittel (T1) und der elektrische Verbraucher (ES) seriell zwischen Ausgänge des Netzteils (100) eingeschleift sind, an denen die Ausgangsspannung (UA) ansteht.

5. Schaltung nach einem der vorhergehenden Ansprüche, **dadurch gekennzeichnet, dass** die Schaltzustandsüberwachungseinheit (200) ein Steuersignal (US) in Abhängigkeit von einem Ergebnis der Überwachung erzeugt, das Netzteil (100) mit dem Steuersignal (US) beaufschlagt und das Netzteil (100) die Ausgangsspannung (UA) mit einem Pegel erzeugt, der von dem Steuersignal (US) abhängt.

6. Schaltung nach Anspruch 5, **dadurch gekennzeichnet, dass** die Schaltzustandsüberwachungseinheit umfasst:
- eine Ansteuerlogikeinheit (201), die in Abhängigkeit von einem Ansteuersignal (UB) für das elektrisch ansteuerbare Schaltmittel (T1) an einem Ausgang (202) ein Rechteckspannungssignal oder ein Gleichspannungssignal erzeugt,
- einen Transistor (T2),
- einen ersten Widerstand (R1),
- eine erste Diode (D1) und eine zweite Diode (D2),
- einen ersten Kondensator (C1) und einen zweiten Kondensator (C2), wobei
- der erste Widerstand (R1) und der erste Kondensator (C1) seriell zwischen einen Verbindungsknoten des elektrisch ansteuerbaren Schaltmittels (T1) und des elektrischen Verbrauchers (ES) und ein Bezugspotential (GND) eingeschleift sind, wobei ein Verbindungsknoten des ersten Widerstands (R1) und des ersten Kondensators (C1) mit einem Steueranschluss des Transistors (T2) verbunden ist,
- der zweite Kondensator (C2) und die erste Diode (D1) seriell zwischen den Ausgang (202) der Ansteuerlogikeinheit (201) und den Steueranschluss des Transistors (T2) eingeschleift sind,
- die Kathode der ersten Diode (D1) mit der Anode der zweiten Diode (D2) und dem zweiten Kondensator (C2) verbunden ist,
- die Kathode der zweiten Diode (D2) mit dem Bezugspotential (GND) verbunden ist und
- das Steuersignal (US) durch den Transistor (T2) erzeugt wird.

7. Schaltung nach Anspruch 6, **dadurch gekennzeichnet, dass** die Schaltzustandsüberwachungseinheit umfasst:
- eine Zenerdiode (D3),
- einen Optokoppler (203),
- einen zweiten Widerstand (R2), wobei
- die Zenerdiode (D3) einer Kollektor-Emitter-Strecke bzw. einer Drain-Source-Strecke des Transistors (T2) parallel geschaltet ist,
- der zweite Widerstand (R2), eine Leuchtdiode (D4) des Optokopplers (203) und die Zenerdiode (D3) seriell zwischen die Ausgänge des Netzteils (100) eingeschleift sind und
- an einem Ausgang des Optokopplers (203) das Steuersignal (US) ansteht.

## Claims

1. Circuit for controlling an electrical load (ES), comprising:
- a power supply (100) generating an output voltage (UA) from an input voltage (UE), the output voltage (UA) being settable,
- an electrically controllable switching means (T1) which depending on its switching state subjects the electrical load (ES) to the output voltage (UA) or does not subject it to the output voltage (UA), and
- a switching state monitoring unit (200) designed
- to monitor the switching state of the switching means (T1) and
- to control the power supply (100) such that the output voltage (UA) of the power supply (100) is altered, in particular reduced, when the switching state of the switching means (T1) does not correspond to a required switching state of the switching means (T1),
**characterized in that**
- the electrical load is an excitation coil (ES) of a relay (RS).

2. Circuit according to Claim 1, **characterized in that** the output voltage (UA) of the power supply (100) is reduced to a voltage level that prevents a pick-up of the relay (RS) or causes a drop-out of the relay when the switching state of the switching means (T1) does not correspond to a required switching state of the switching means (T1).

3. Circuit according to Claim 1 or 2, **characterized in that** the electrically controllable switching means is a transistor (T1).

4. Circuit according to one of the preceding claims, **characterized in that** the circuit comprises the electrical load (ES), where the electrically controllable switching means (T1) and the electrical load (ES) are looped in serially between outputs of the power supply (100) at which the output voltage (UA) is applied.

5. Circuit according to one of the preceding claims, **characterized in that** the switching state monitoring unit (200) generates a control signal (US) depending on a result of the monitoring, subjects the power supply (100) to the control signal (US) and the power supply (100) generates the output voltage (UA) with a level depending on the control signal (US).

6. Circuit according to Claim 5, **characterized in that** the switching state monitoring unit comprises:
- a control logic (201) which, depending on an actuating signal (UB) for the electrically controllable switching means (T1), generates at an output (202) a square wave voltage signal or a DC voltage signal,
- a transistor (T2),
- a first resistor (R1),
- a first diode (D1) and a second diode (D2),
- a first capacitor (C1) and a second capacitor (C2), where
- the first resistor (R1) and the first capacitor (C1) are looped in serially between a connecting node of the electrically controllable switching means (T1) and of the electrical load (ES) and a reference potential (GND), where a connecting node of the first resistor (R1) and of the first capacitor (C1) is connected to a control connection of the transistor (T2),
- the second capacitor (C2) and the first diode (D1) are looped in serially between the output (202) of the control logic unit (201) and the control connection of the transistor (T2),
- the cathode of the first diode (D1) is connected to the anode of the second diode (D2) and the second capacitor (C2),
- the cathode of the second diode (D2) is connected to the reference potential (GND) and
- the control signal (US) is generated by the transistor (T2).

7. Circuit according to Claim 6, **characterized in that** the switching state monitoring unit comprises:
- a zener diode (D3),
- an optocoupler (203),
- a second resistor (R2) where
- the zener diode (D3) of a collector-emitter path or a drain source path of the transistor (T2) is connected in parallel,
- the second resistor (R2), an LED (D4) of the optocoupler (203) and the zener diode (D3) are looped in serially between outputs of the power supply (100) and
- the control signal (US) is applied at an outlet of the optocoupler (203).

## Revendications

1. Commutateur destiné à la commande d'un récepteur électrique (ES) comprenant :
- une unité d'alimentation (100) qui produit une tension de sortie (UA) à partir d'une tension d'entrée (UE), sachant que la tension de sortie (UA) est réglable,
- un moyen de commutation (T1) à commande électrique qui, en fonction de son état de commutation, alimente le récepteur électrique (ES) avec la tension de sortie (UA) ou n'alimente pas le récepteur avec la tension de sortie (UA), et
- une unité de surveillance de l'état de commutation (200) destinée à
- surveiller l'état de commutation du moyen de commutation (T1) et
- à commander l'unité d'alimentation de telle manière que la tension de sortie (UA) de l'unité d'alimentation (100) est modifiée, en particulier réduite, lorsque l'état de commutation du moyen de commutation (T1) ne correspond pas à un état de commutation souhaité du moyen de commutation (T1),
**caractérisé en ce que**
- le récepteur électrique est une bobine d'excitation (ES) d'un relais (RS).

2. Commutateur selon la revendication 1, **caractérisé en ce que** la tension de sortie (UA) de l'unité d'alimentation (100) est réduite jusqu'à un niveau de tension qui empêche une excitation du relais (RS) ou entraîne une retombée du relais (RS), lorsque l'état de commutation du moyen de commutation (T1) ne correspond pas à un état de commutation souhaité du moyen de commutation (T1).

3. Commutateur selon la revendication 1 ou 2, **caractérisé en ce que** le moyen de commutation à commande électrique est un transistor (T1).

4. Commutateur selon l'une des revendications précédentes, **caractérisé en ce que** le commutateur comprend le récepteur électrique (ES), sachant que le moyen de commutation (T1) à commande électrique et le récepteur électrique (ES) sont branchés en série entre les sorties de l'unité d'alimentation (100) sur lesquelles la tension de sortie (UA) est appliquée.

5. Commutateur selon l'une des revendications précédentes, **caractérisé en ce que** l'unité de surveillance de l'état de commutation (200) produit un signal de commande (US) en fonction d'un résultat de la surveillance, fournit à l'unité d'alimentation (100) le signal de commande (US) et **en ce que** l'unité d'alimentation (100) produit la tension de sortie (UA) dont le niveau dépend du signal de commande (US).

6. Commutateur selon la revendication 5, **caractérisé en ce que** l'unité de surveillance de l'état de commutation comprend :
- une unité de circuit logique (201) qui produit un signal à tension rectangulaire ou un signal à tension continue en fonction d'un signal de commande (UB) pour le moyen de commutation (T1) à commande électrique sur une sortie (202),
- un transistor (T2),
- une première résistance (R1),
- une première diode (D1) et une seconde diode (D2),
- un premier condensateur (C1) et un second condensateur (C2), sachant que
- la première résistance (R1) et le premier condensateur (C1) sont branchés en série entre un noeud de liaison du moyen de commutation (T1) à commande électrique et du récepteur électrique (ES) et un potentiel de référence (GND), sachant qu'un noeud de liaison de la première résistance (R1) et du premier condensateur (C1) est relié à une gâchette du transistor (T2),
- le second condensateur (C2) et la première diode (D1) sont branchés en série entre la sortie (202) de l'unité de circuit logique (201) et la gâchette du transistor (T2),
- la cathode de la première diode (D1) est reliée à l'anode de la seconde diode (D2) et au second condensateur (C2),
- la cathode de la seconde diode (D2) est reliée au potentiel de référence (GND) et
- le signal de commande (US) est produit par le transistor (T2).

7. Commutateur selon la revendication 6, **caractérisé en ce que** l'unité de surveillance de l'état de commutation comprend :
- une diode Zener (D3),
- un optocoupleur (203),
- une seconde résistance (R2), sachant que
- la diode Zener (D3) d'une jonction collecteur-émetteur ou d'une jonction drain-source du transistor (T2) est branchée en parallèle,
- la seconde résistance (R2), une diode électroluminescente (D4) de l'optocoupleur (203) et la diode Zener (D3) sont branchées en série entre les sorties de l'unité d'alimentation (100), et
- le signal de commande (US) est appliqué à une sortie de l'optocoupleur (203).
